# EUROPEAN PATENT APPLICATION

(11) **EP 1 813 657 A2**
(43) Date of publication of application: **01.08.2007**
(21) Application number: 07002005.2
(22) Date of filing: 30.01.2007
(51) Int. Cl.: C09G 1/02, C09K 3/14

(54) **Metal-polishing liquid and chemical-mechanical polishing method using the same**

(30) Priority: 31.01.2006 JP 2006023203; 31.01.2006 JP 2006023205
(71) Applicant: Fujifilm Corporation, Minato-ku Tokyo (JP)
(72) Inventor: Kikuchi, Makoto, Haibara-gun Shizuoka-ken (JP)
(74) Representative: HOFFMANN EITLE

(57) **Abstract**

A metal-polishing liquid contains at least one heterocyclic compound having from one to three nitrogen atom as heteroatoms in a molecule; and colloidal silica having a surface partially covered with aluminum. A chemical-mechanical polishing method contains processes of supplying the metal-polishing liquid to a polishing pad on a polishing platen; rotating the polishing platen; relatively moving the polishing pad while the polishing pad is contacted with a surface to be polished of an object to be polished; and polishing the surface to be polished of the object to be polished.

## Description

### BACKGROUND OF THE INVENTION

### Field of the invention

The present invention relates to a metal-polishing liquid used for planarization by a chemical-mechanical polishing method in the process for manufacturing a semiconductor device, and a polishing method using the same.

### Description of the Related Art

In the development of semiconductor devices, as represented by a large-scale integrated circuit (hereinafter, referred to as LSI), densification and enhancement of integration by poly-lamination of and formation of finer wiring have recently been demanded for the purpose of miniaturization and higher speed. For these purposes, a variety of techniques such as Chemical Mechanical Polishing (hereinafter, referred to as CMP) have been used. This CMP is an essential technique when surface flattening of processed films such as an interlayer insulating film, plug formation, formation of embedded metal wiring, or the like is carried out, and removes an extra metal thin film during substrate smoothing and wire formation. A description of this technique can be found in, for example, U. S. Patent No. 4944836.

A general CMP method involves sticking a polishing pad on a circular polishing platen, soaking the surface of the polishing pad with a polishing liquid, pushing the surface of a wafer on the pad, rotating both the polishing platen and the wafer under conditions of a specified pressure (polishing pressure) from the back surface side of the wafer, and flattening the wafer surface by means of generated mechanical friction.
The metal-polishing liquid used for CMP usually contains an abrasive (for example alumina or silica) and an oxidant (for example hydrogen peroxide or persulfuric acid). The basic mechanism of polishing is considered to include a process for oxidizing the surface of a metal with the oxidant, and a process for removing the oxidized film with the abrasive. The method is described, for example, in Journal of Electrochemical Society, 1991, vol. 138, No. 11, pp 3460-3464.

Conventionally, tungsten and aluminum have been generally used as metals for wiring in interconnection structures. With the aim of higher performance, however, LSIs have been developed in which copper having a wiring resistance lower than those of these metals is used. The Damascene method is known as a method of forming wiring with this copper (see, for example, Japanese Patent Application Laid-Open (JP-A) No. 2-278822). Additionally, the dual Damascene method has been widely used which involves simultaneously forming both a contact hole and a wiring groove in an interlayer insulating film, and embedding a metal in the both of these. Since copper is an especially soft metal, polishing of the copper metal requires higher accuracy of the polishing technology. A high-speed metal-polishing means is also required for attaining high productivity.

Recently, for the purpose of miniaturizing increased miniaturizing the semiconductor device and for making the response of the semiconductor device high-speed, Higher densification and higher integration by making the wiring to be finer and to be more highly integrated have been particularly required in recent years. Accordingly, reduction of dishing phenomenon by which the wiring metal portion is depressed like a dish by being excessively polished and reduction of erosion phenomenon by which plural kinds of metal surfaces are depressed while insulating bodies between the metal wirings are excessively polished are urgently desired.

The inventors of the present invention have investigated the erosion phenomena, and found that erosion increases by using abrasives having a larger size. These phenomena are considered to be mainly caused by aggregation of the abrasives. For solving the problem, JP-A No. 2003-197573 discloses a technology for reducing scratches by using a polishing liquid containing abrasives comprising colloidal silica having a surface covered with aluminum in order to reduce aggregation of particles.
However, an attempt by the inventors of the present invention using the above-mentioned technology showed that compatibility between high-speed polishing and reduction of erosion was insufficient.

A study on the dishing phenomenon by the inventors of the present invention showed that using the abrasives having a larger size makes the size of dishing large. The cause of this result seems to principally depend on aggregation of the abrasives. For solving the problem, JP-A 2003-197573 discloses, for example, that scratches may be reduced by using a polishing liquid containing abrasives comprising colloidal silica having a surface partially covered with aluminum.
However, an attempt by the inventors of the present invention using the technology described in the above-mentioned patent document showed that compatibility between high-speed polishing and reduction of erosion was insufficient.

### SUMMARY OF THE INVENTION

The metal-polishing liquid according to the present invention includes at least one heterocyclic compound having from one to three nitrogen atom as heteroatoms in a molecule, and colloidal silica having a surface partially covered with aluminum.

### DETAILED DESCRIPTION OF THE INVENTION

The present invention will be described in detail below. In the present specification "... to ..." represents a range including the numeral values represented before and after "to" as a minimum value and a maximum value, respectively.

### [Metal-polishing liquid]

The inventors of the present invention found by studied earnestly that compatibility between high polishing speed and low erosion is possible by using the metal-polishing liquid with a composition shown below for polishing a polishing object (a wafer).

A first aspect of the present invention provides a metal-polishing liquid comprising at least one of heterocyclic compounds containing from one to three nitrogen atoms as heteroatoms in a molecule, and a colloidal silica having a surface partially covered with aluminum.

### <Metal-polishing liquid>

The metal-polishing liquid according to the first aspect of the present invention (hereinafter, may be referred to as a" first metal polishing liquid".) includes, as essential components, at least one of heterocyclic compounds having from one to three nitrogen atoms as heteroatoms in a molecule, and a colloidal silica having a surface partially covered with aluminum, furthermore, organic acids and oxidants may be preferably include thereto. The metal-polishing liquid is usually a slurry prepared by dispersing colloidal silica (abrasives) into an aqueous solution prepared by dissolving the above-mentioned each component.
As a preferable aspect, the heterocyclic compound contained in the metal-polishing liquid has at least one carboxylic group.
As another aspect of the present invention, the metal-polishing liquid preferably has a pH of 2 to 9, more preferably 5 to 8.

Each component constituting the metal-polishing liquids will be described in detail below. Each component may be used alone, or in combination of plural kinds of the components.

The "metal-polishing solution" as used in the present invention refers to not only a polishing liquid having a composition (concentration) when used for polishing, but also a condensed liquid of the polishing liquid used by dilution, if necessary, unless otherwise specified. The condensed liquid is used for polishing by diluting with an aqueous solution or water before use, and the dilution factor is usually 1 to 20 times by volume.

### [Heterocyclic compound containing from one to three nitrogen atoms as heteroatoms in the molecule]

The first metal-polishing liquid according to the present invention contains at least one heterocyclic compound (hereinafter, simply referred to as a "heterocyclic compound" in some cases) having from one to three nitrogen atoms as heteroatoms in the molecule as compounds for forming passive films on the surface of a metal as a polishing object.
The "heterocyclic compound" as used in the present invention refers to a compound having a hetero-ring containing at least one heteroatom. The heteroatom means an atom other than a carbon atom or a hydrogen atom, and the hetero-ring means a cyclic compound having at least one heteroatom.
The heteroatom such as a nitrogen atom means only the atom forming a constituting portion of the ring structure in the hetero-ring, and does not mean atom positioned outside the ring structure, separated from the ring structure through at least one non-conjugated single bond, and being a part of an additional substituent of the ring structure.

The heterocyclic compound of the present invention contains from one to three nitrogen atoms as the atoms for forming the ring constituting portion, furthermore may contain heteroatom other than nitrogen atom as the atoms for forming the ring constituting portion.
Examples of the heteroatom other than nitrogen atom constituting the heterocyclic compound of the present invention preferably include a sulfur atom, an oxygen atom, a selenium atom, a tellurium atom, a phosphor atom, a silicon atom or a boron atom.

A heterocyclic ring to be main structure will be described below.
A number of the ring members of the heterocyclic ring of the heterocyclic compound is not particularly restricted, and the heterocyclic compound may be a monocyclic compound or a polycyclic compound. The number of the ring-forming atoms of the monocyclic compound is preferably 3 to 8, more preferably 5 to 7, and further preferably 5 or 6. The number of the ring-forming atoms of the condensed ring is preferably 2 to 4, and more preferably 2 or 3.

While specific examples of the heterocyclic ring include as follows, they are not restricted thereto.
The examples include a pyrrole ring, an imidazole ring, a pyrazole ring, a thiazole ring, an oxazole ring, a pyridine ring, a pyrazine ring, a pyrimidine ring, a pyridazine ring, an indazole ring, a quinoline ring, a phthalazine ring, a quinoxaline ring, a quinazoline ring, a cinnoline ring, a pteridine ring, an acridine ring, a perimidine ring, a phenanthroline ring, a thiadiazole ring, an oxadiazole ring, a benzimidazole ring, a benzoxazole ring, a benzthiazole ring, a benzthiadiazole ring or a naphthoimidazole ring. Among them, the pyridine ring, quinoline ring, imidazole ring, benzimidazole ring, pyrazole ring and indazole ring are preferable.

The metal-polishing liquid according to the present invention preferably comprises, triazole compounds, which have three nitrogen atoms as heteroatoms in the molecule, as one of the heterocyclic compound. Condensed rings may be included in the molecule of the triazole compound.
Specific examples of the main structure constituting the triazole compound include 1,2,3-triazole, 1,2,4-triazole and benzotriazole. Among them, 1,2,3-triazole and 1,2,4-triazole are preferably used.

The triazole compound used in the present invention may be a derivative in which the following substituents are introduced into the main structure (heterocyclic portion) of the above-mentioned compound.

The substituent that may be incorporated in the heterocyclic ring will be described below.
When a specific portion is named as "group" in the present invention, it means that the portion may not be substituted, per se, or may be substituted with one or more (up to possible largest number) substituents. For example "alkyl group" denotes a substituted or non-substituted alkyl group.

Examples of the substituent that may be incorporated in the heterocyclic ring are as follows.
They include a halogen atom (fluorine atom, chlorine atom, bromine atom or iodine atom), an alkyl group (linear, branched or cyclic alkyl group; the group may be a polycyclic alkyl group such as bicyclo-alkyl group, or may include an active methine group), an alkenyl group, an alkynyl group, an aryl group, a heterocyclic group (substituted site is not restricted), an acyl group, an alkoxycarbonyl group, an aryloxycarbonyl group, a heterocyclic oxycarbonyl group, a carbamoyl group (examples of the carbamoyl group having substituents include an N-hydroxycarbamoyl group, an N-acylcarbamoyl group, an N-sulfonylcarbamoyl group, an N-carbamoylcarbamoyl group, an thiocarbamoyl group and an N-sulfamoylcarbamoyl group), a carbazoyl group, a carboxyl group or salts thereof, an oxalyl group, an oxamoyl group, a cyano group, a carbonimidoyl group, a formyl group, a hydroxyl group, an alkoxy group (including groups having repeated ethyleneoxy or propyleneoxy groups), an aryloxy group, a heterocyclicoxy group, an acyloxy group, an (alkoxy or aryloxy)carbonyl group, a carbamoyloxy group, a sulfonyloxy group, an amino group, an (alkyl, aryl or heterocyclic)amino group, an acylamino group, a sulfonamide group, an ureido group, a thioureido group, an N-hydroxyureido group, an imido group, an (alkoxy or aryloxy)carbonylamino group, a sulfamoylamino group, a semicarbazide group, a thiosemicarbazide group, a hydrazino group, an ammonio group, an oxamoylamino group, an N-(alkyl or aryl)sulfonylureido group, an N-acyl ureido group, an N-acyl sulfamoylamino group, a hydroxyamino group, a nitro group, a heterocyclic rings containing quaternarized nitrogen atoms (for example pyridinio, imodazolio, quiolinio or isoquinolinio group), an isocyano group, an imino group, a mercapto group, an (alkyl aryl or heterocyclic)thio group, an (alkyl, aryl or heterocyclic)dithio group, an (alkyl or aryl)sulfonyl group, an (alkyl or aryl)sulfinyl group, a sulfo group or salts thereof, a sulfamoyl group (examples of the sulfamoyl group having substituents include an N-acylsulfamoyl group or an N-sulfonylsulfamoyl group) or salts thereof, a phosphino group, a phosphinyl group, a phosphinyloxy group, a phosphinylamino group or a silyl group. However, the example is not restricted to these substituents.

The active methine group refers to a methine group substituted with two electron-attracting groups. Examples of the electron-attracting group include acyl group, alkoxycarbonyl group, aryloxycarbonyl group, carbamoyl group, alkylsulfonyl group, arylsulfonyl group, sulfamoyl group, trifluoromethyl group, cyano group, nitro group and carbonimidoyl group. Two electron-attracting groups may link to each other to form a cyclic structure.
Salts include cations such as alkali metals, alkaline earth metals and heavy metals, and organic cations such as organic ammonium ions and phosphonium ions.

The heterocyclic compound used in the present invention preferably has at least one carboxylic group, more preferably plural kinds of carboxylic groups.
Specific examples of the carboxylic acid include quinaldic acid, pyridine-3,4-dicarboxylic acid, quinoline-2-carboxylic acid, imidazole-4-carboxylic acid, benzimidazole-4-carboxylic acid, pyrazole-4-carboxylic acid and indazole-3-carboxylic acid.

Examples of the triazole compound used in the present invention preferably include 1,2,3-triazole, 1,2,4-triazole, 3-hydroxy-1,2,4-triazole, 1,2,3-triazole-4,5-dicarboxylic acid or the like.

The heterocyclic compound used in the present invention may be used alone, or in combination of plural kinds of the components.
The heterocyclic compound used in the present invention may be synthesized by conventional method, or may be used a commercially available compound.

The total amount of the heterocyclic compound added into the metal-polishing liquid is preferably in the range of from 0.0001 to 1.0 mol, more preferably 0.0002 to 0.1 mol, and furthermore preferably 0.0002 to 0.01 mol with respect to 1 L of the metal-polishing liquid when used for polishing (hereinafter, the metal-polishing liquid after dilution when the liquid is diluted with water or an aqueous solution may be referred to as a "metal-polishing liquid when used for polishing"). The addition amount of the heterocyclic compound is preferably 0.0001 mol or more from viewpoint of reducing erosion, and preferably 1.0 mol or less ifrom viewpoint of maintaining high-speed polishing.

### [Colloidal silica having a surface partially covered with aluminum]

The metal-polishing liquid according to the present invention contains a colloidal silica having a surface partially covered with aluminum, as at least a part of abrasives. This colloidal silica is referred to as a "specified colloidal silica", as needed.
In the present invention, the phrase "colloidal silica having a surface partially covered with aluminum" means a state in which aluminum atoms are present on the surfaces of colloidal silica having sites containing silicon atoms with a coordination number of 4 and may also be a state in which an aluminum atom having 4 oxygen atoms coordinated thereto binds to the colloidal silica surface to generate a new surface in which the aluminum atom is immobilized in a tetracoordinate state or a state in which a silicon atom present on the surface is once extracted and substituted by an aluminum atom to form a new surface.

Colloidal silica used for preparing the specified colloidal silica is preferably obtained by method of hydrolysis of alkoxysilane, because there are no impurities such as alkali metals in the particl in case of using the method. As another manufacturing method for colloidal silica, a method of removing alkali from an aqueous alkali silicate may be used, however alkali metals remaining in the particle might be slowly dissolved out, and thus polishing performance may be impaired. Accordingly, the colloidal silica obtained by hydrolysis of alkoxysilane is more preferable as a raw material.
The particle diameter of colloidal silica is appropriately selected depending on the purpose of use of the abrasives. It is usually in the range of from 10 to 200 nm.

An example of a method, which is used for obtaining the specified colloidal silica, is preferably a method of adding an aluminic acid compound such as sodium aluminate into a dispersion solution of colloidal silica. This method is described in detail in Japanese Patent No. 3463328 and JP-A No. 63-123807, and the method may be applied to the present invention.
Another method is method of adding aluminum alkoxide into a dispersion solution of colloidal silica.
While arbitrary aluminum alkoxide may be used in this method, it is preferably aluminum isopropoxide, aluminum butoxide, aluminum methoxide or aluminum ethoxide, and more preferably aluminum isopropoxide or aluminum butoxide.

The specified colloidal silica obtained by the above method has an aluminosilicate site which is formed by a reaction of four-coordinated aluminum ions with silanol groups on the surface of colloidal silica. This aluminosilicate site fixes negative charges, and gives a large negative zeta-potential to the particles. Consequently, the specified colloidal silica becomes excellent in dispersibility even under an acidic condition.
Accordingly, it is important for specified colloidal silica manufactured by the above-mentioned method that the aluminum atom is coordinated with four oxygen atoms.

The aluminum atom, which is coordinated with four oxygen atoms on the surface of the specified colloidal silica, can be confirmed, for example, by measuring the zeta-potential.

The amount of aluminum atoms covering on the surface of colloidal silica is shown as a percentage of substitution of surface atoms of the colloidal silica (a number of introduced aluminum atoms / a number of surface silicon atom sites). The percentage of substitution is preferably 0.001% to 20%, more preferably 0.01% to 10%, and furthermore preferably 0.1% to 5%.
When silicon atoms on the colloidal silica surface are substituted for aluminum atoms, the amount of substitution for aluminum atoms may be controlled, as appropriate, by controlling the amount (concentration) of an aluminate compound, an aluminum alkoxide or the like added into the dispersion solution of colloidal silica.

The surface substitution ratio of the specified colloidal silica (number of introduced aluminum atoms / number of surface silicon atom sites) may be determined as follows.
The consumed amount of the aluminum compound added into the dispersion solution is calculated from the amount of the unreacted aluminum compound remaining after the reaction. The surface substitution ratio may be estimated from the surface area of colloidal silica calculated from the diameter of colloidal silica, the specific gravity (2.2) of colloidal silica and the number of the silanol groups per unit surface area (5 to 8 groups/nm²), on the assumption that 100% of the consumed aluminum compound has reacted with colloidal silica. In a practical measurement, specified colloidal silica, per se, is subjected to elementary analysis, and the ratio is determined using the surface area, specific gravity and the number of silanol groups per unit surface area, on the assumption that aluminum does not exist inside of the particle but is uniformly and thinly spread on the surface.

Specific manufacturing method of the specified colloidal silica of the present invention will be described below.
A colloidal silica is dispersed in water in a range of from 1 to 50% by mass, and then the pH of the dispersion solution is adjusted in the range of from 7 to 11. Successively, an aqueous solution of sodium aluminate is added under stirring at near room temperature, and stirring is continued for additional 0.5 to 10 hours to be sol.
Impurities are removed from the sol thus obtained by ion-exchange or ultrafiltration to obtain specified colloidal silica.

The size (an average value of the volume equivalent diameter) of the specified colloidal silica obtained is preferably in the range of from 3 to 200 nm, more preferably 5 to 100 nm, and furthermore preferably 10 to 60 nm.
The particle diameter (volume equivalent diameter) of the specified colloidal silica is measured by dynamic light scattering method.

The content of the specified colloidal silica in the metal-polishing liquid according to the present invention is preferably in the range of from 0.001% by mass to 5% by mass, more preferably 0.01% by mass to 0.5% by mass, and furthermore preferably 0.05% by mass to 0.2% by mass with respect to the mass of the metal-polishing liquid when used for polishing g in order to exhibit its effect.

The content of the specified colloidal silica, with respect to the abrasives contained in the metal-polishing liquid according to the present invention, is preferably 50% by mass or more, and more preferably 80% by mass or more. All the abrasives contained in the metal-polishing liquid may be the specified colloidal silica.

Examples of abrasives other than the specified colloidal silica preferably include fumed silica, colloidal silica, ceria, alumina and titania, and more preferably colloidal silica. The size of these abrasives is preferably in a range of from equal to twice of the specified colloidal silica.

In the metal-polishing liquid according to the present invention, the content of the above heterocyclic compound with respect to the content of the specified colloidal silica (the heterocyclic compound / the specified colloidal silica) (by mass) is preferably in the range of from 0.00002 to 1000, more preferably 0.0002 to 100 , and further preferably 0.02 to 10.

### [Oxidant]

The metal-polishing liquid according to the present invention preferably contains a compound capable of oxidizing a metal which is the polishing object (oxidant).
Specific example of the oxidant include hydrogen peroxide, peroxides, nitrate salts, iodic acid salts, periodic acid salts, hypochlorous acid salts, chlorite, chlorate, perchlorate, persulfate, bichromic acid salts, permanganic acid salts, aqueous ozone, and silver (II) and iron (II) salts. Among them, hydrogen peroxide is preferably used.

The addition amount of the oxidant is preferably in the range of from 0.003 to 8 mol, more preferably 0.03 to 6 mol, and furthermore preferably 0.1 to 4 mol with respect to 1 L of the metal-polishing liquid when used for polishing. The addition amount of the oxidant is preferably 0.003 mol or more from the viewpoint of ensuring sufficient oxidation of the metal and high CMP speed, while a range of 8 mol or less is preferable for preventing the surface to be polished from being roughened.

### [Organic acid]

The metal-polishing liquid according to the present invention preferably contains at least one organic acid. The organic acid as used herein is not an oxidant of the metal, but has function of accelerating oxidation, of adjusting the pH and as a buffer agent.
Examples of the organic acid include amino acids.

Water soluble organic acids are preferable, and those selected from the compounds below are more suitable.
Examples of the organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, hydroxyethylimino diacetic acid, imino diacetic acid, dihydroxyethyl glycine, tricin, Nitrilotrimethylene(phosphonic acid), ammonium salts or alkalimetal salts of these acids, sulfuric acid, nitric acid, ammonia or ammonium salts of these acids, or mixtures of these acids. Among them, oxalic acid, formic acid, malonic acid, malic acid, tartaric acid, citric acid, hydroxyethylimino diacetic acid, imino diacetic acid and dihydroxyethyl glycine are favorable.

As the organic acid, water soluble amino acid is preferably, and those selected from the following group are more suitable.
They include glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiodo-L-thyrosine, β-(3,4-dihydroxyphenyl)-L-alanine, L-thyroxine, 4-hydroxy-L-proline, L-cysteine, L-methionine, L-ethionine, L-lanthionine, L-cystathionine, L-cystine, L-cycteic acid, L-asparagic acid, L-glutamic acid, S-(carboxymethyl)-L-cysteine, 4-aminobutyric acid, L-asparagine, L-glutamine, azaserine, L-arginine, L-canavanine, L-citrulline, δ-hydroxyl-L-lysine, creatine, L-kynurenine, L-hystidine, 1-methyl-L-hystidine, 3-methyl-L-hystidine, ergothioneine, L-tryptophane, actinomycin C1, apamin, angiotensin I, angiotensin II and antipain.
Malic acid, tartaric acid, citric acid, glycine, glycolic acid, β-alanine, hydoxyethyliminodiacetic acid, iminodiacetic acid or hydroxyethyl glycine are more preferable from viewpoint of controlling the etching speed while a practical CMP speed is maintained.

The addition amount of the organic acid is preferably 0.005 to 0.5 mol, more preferably 0.01 to 0.3 mol, and particularly preferably 0.05 to 0.3 mol with respect to 1 L of the metal-polishing liquid when used for polishing. The addition amount of the organic acid is preferably 0.01 mol or more from viewpoint of improving the polishing speed, while the amount is preferably 0.3 mol or less from viewpoint of preventing dishing from being worsened.

The organic acid may be used alone in the metal-polishing liquid according to the present invention, or in combination of plural kinds of the components.
These organic acids may be synthesized according to a conventional method, or may be used a commercially available compound.

The metal-polishing liquid may contain other components such as a surfactant, hydrophilic polymer and other additives.

### [Surfactant / hydrophilic polymer]

The metal-polishing liquid of the present invention preferably contains a surfactant and/or hydrophilic polymer.
The surfactant and hydrophilic polymer have a function for reducing the contact angle of the surface of the polishing object, and help the surface be uniformly polished. The surfactant and hydrophilic polymer used are favorably selected from the following groups.

Examples of the anionic surfactant include carboxylic acid salts, sulfonic acid salts, sulfonic acid ester salts and phosphoric acid ester salts.
Examples of the cationic surfactant include aliphatic amine salts, aliphatic quaternary ammonium salts, benzalkonium chloride salts, benzetonium chloride salts, pyridinium salts or imidazolinium salts.
Examples of the amphoteric surfactant include carboxybetaine type, aminocarboxylic acid salts, imidazilinium betaine, lecithin or alkylamine oxide.
Examples of the nonionic surfactant include ester type, ether ester type, ester type or nitrogen-containing surfactants.
Fluorinated surfactants may be also used.

Examples of the hydrophilic polymer include polyglycols such as polyethyleneglycol; polyvinyl alcohol; polyvinyl pyrrolidone; polysaccharides such as alginic acid; or carboxylic acid-containing polymers such as polymethacrylic acid.

As the above surfactant and hydrophilic polymer, acids or ammonium salts of the acids are preferable from viewpoint of preventing contamination with alkali metals, alkaline earth metals, halogenated compounds thereof or the like. Among the above-mentioned compounds, cyclohexanol, ammonium polyacrylate, polyvinyl alcohol, succinamide, polyvinyl pyrrolidone, polyethyleneglycol and polyoxyethylene-polyoxypropylene block polymer are more preferable.

The weight average molecular weight of these surfactants and hydrophilic polymer is preferably in the range of from 500 to 100,000, particularly preferably 2,000 to 50,000.

The total addition amount of the surfactant and/or hydrophilic polymer is preferably in the range of from 0.001 to 10 g, more preferably 0.01 to 5 g, and furthermore preferably 0.1 to 3 g with respect to 1 L of the metal-polishing liquid when used for polishing.

### [pH controlling agent]

The metal-polishing liquid according to the present invention preferably includes an acidic agent, an alkaline agent or a buffering agent for adjusting to be a predetermined pH.
The acidic agent preferably includes an inorganic acid. While sulfuric acid, nitric acid, boric acid and phosphoric acid are used as the inorganic acids, sulfuric acid is preferable among them.
Examples of the alkaline agent or buffering agent include non-metallic alkaline agent for example, ammonia; organic ammonium hydroxide such as ammonium hydroxide or tetramethylammonium hydroxide; alkanol amines such as diethanolamine, triethanolamine or triisopropanol amine: alkali metal hydroxides such as sodium hydroxide, potassium hydroxide or lithium hydroxide: carbonic acid salts such as sodium carbonate: phosphoric acid salts such as trisodium phosphate: boric acid salts: tetraboric acid: hydroxybenzoic acid or the like.
Preferable alkaline agents include ammonium hydroxide, potassium hydroxide, lithium hydroxide or tetramethylammonium hydroxide.

The addition amount of the pH controlling agent is not restricted, as long as the pH is maintained in a preferable range. The amount is preferably in a range of from 0.0001 to 1.0 mol, and more preferably 0.003 to 0.5 mol with respect to 1 L of the metal-polishing liquid.
The pH of the metal-polishing liquid when used for polishing is preferably in the range of from 3 to 12, more preferably 4 to 9, and furthermore preferably 5 to 8. The effect of the metal-polishing liquid is particularly excellent in this pH range.
The pH of the metal-polishing liquid can be adjusted in the above-mentioned range by using the acidic agent, alkaline agent or buffering agent.

### [Chelating agent]

The metal-polishing liquid according to the present invention may contain a chelating agent (i.e. demineralizing agent for hard water), if necessary, for reducing an adverse effect caused by mingling of polyvalent metal ions.
As the chelating agent, a generally demineralizing agent for hard water may be used for a precipitation preventing agent of calcium and magnesium or a related compound thereof. The agent may be used alone, or in combination of plural kinds of the components as needed.
The addition amount of the chelating agent is not restricted, as long as the amount is sufficient for blocking metal ions such as contaminated polyvalent metal ions. The chelating agent is added, for example, such that the concentration is preferably in the range of from 0.0003 to 0.07 mol with respect to 1 L of the metal-polishing liquid when used for polishing.

### <Chemical-mechanical polishing method>

A second aspect of the present invention provides a chemical-mechanical polishing method. The method includes the processes of: supplying the metal-polishing liquid according to the present invention to a polishing pad on a polishing platen; rotating the polishing platen; and relatively moving the polishing pad while the polishing pad is contacted with a surface to be polished of an object to be polished to polish the surface to be polished of the object to be polished.
The chemical-mechanical polishing method will be described in detail below.

### (Polishing apparatus)

First, the apparatus available for the polishing method of the present invention will be described below.
A conventionally used polishing apparatus includes a holder for holding a polishing object (such as a semiconductor substrate) having a surface to be polished; and a polishing platen (equipped with a rotation speed-variable motor) on which a polishing pad is bonded. An example of the polishing apparatus available is FREX 300 (trade name, manufactured by Ebara Corporation).

### (Polishing pressure)

The polishing pressure, i.e. a contact pressure between the surface to be polished and polishing pad, is preferably in the range of from 3,000 to 250,000 Pa, and more preferably 6,500 to 14,000 Pa in the polishing method of the present invention.

### (Rotation speed of polishing platen)

The rotation speed of the polishing platen in the polishing method according to the present invention is preferably in the range of from 50 to 200 rpm, and more preferably 60 to 150 rpm.

### (Feeding method of metal-polishing liquid)

The metal-polishing liquid is continuously supplied to the polishing pad on the polishing platen with a pump while a metal as a polishing subject is polished. While the supply amount is not restricted, it is preferable that the surface of the polishing pad is steadily covered with the polishing liquid.

A condensed polishing liquid may be used in the polishing method of the present invention after diluting the liquid with water or an aqueous solution. The dilution method includes, for example, allowing a pipeline for feeding the condensed polishing liquid to join with a pipeline for feeding water or an aqueous solution at the midway of the feed pipeline, mixing the condensed polishing liquid and diluting liquid, and feeding the diluted polishing liquid to the polishing pad. The mixing method includes conventionally used methods such as a method for allowing two liquids after passing through a narrow conduit to collide to each other for mixing them, a method for allowing the stream of the liquid to repeatedly separate and join by blocking the stream with fillers such as glass tubes in the pipeline, and a method for providing a blade that rotates with a motive power in the pipeline.

Another dilution method available in the present invention includes the processes of: independently providing a pipeline for feeding the polishing liquid and a pipeline for feeding water or an aqueous solution; supplying a predetermined amount of liquid from each of the pipelines to the polishing pad; and moving relatively between the polishing pad and the surface to be polished.
In a different method available in the present invention, predetermined amounts of condensed polishing liquid and water or an aqueous solution is filled and mixed in one vessel, and the mixed liquid after diluting so as to be a predetermined concentration is supplied to the polishing pad.

In a further different method available in the present invention, the components to be incorporated in the polishing liquid is divided into at least two constituents, and the components are supplied to the polishing pad with dilution by adding water or an aqueous solution. The liquids are preferably divided into a component containing the oxidant and a component containing the organic acid before supplying to the polishing pad.

Specifically, the oxidant is selected as one constituent (A); and the organic acid, additive, surfactant, heterocyclic compounds(containing the triazole compounds), abrasives (containing specified colloidal silica) and water is selected as the other constituent (B). When they are used, component (A) and component (B) are diluted with water or an aqueous solution. In this case, three pipelines for feeding constituent (A), constituent (B) and water or an aqueous solution, respectively, are necessary. The three pipelines are joined to a pipeline for feeding the liquids to the polishing pad. The liquids may be mixed in the latter pipeline, or may be mixed by joining two pipelines followed by joining the third pipeline. For example, a constituent containing a hardly soluble additive is mixed with the other constituents, and the polishing liquid is supplied by joining the pipeline for water or an aqueous solution after securing a dissolution time by elongating the mixing passageway.

Otherwise, three pipelines are guided to the polishing pad, and the liquids may be supplied while the liquids are mixed by the relative movement between the polishing pad and the surface to be polished, or a mixed liquid may be supplied to the polishing pad after mixing the tree constituents in one vessel. Further, the metal-polishing liquid may be prepared as a condensed liquid, and water may be independently supplied to the surface to be polished.

### (Supply amount of polishing liquid)

The amount of the polishing liquid supplied onto the polishing platen in the polishing method of the present invention is preferably in the range of from 50 to 500 ml/min, and more preferably 100 to 300 ml/min.

### (Polishing pad)

The polishing pad used in the polishing method of the present invention is not particularly restricted, and either a pad of a non-foamed structure or a pad of a foamed structure may be used. A rigid bulk material of a synthetic resin such as a plastic plate is used for the former, while the latter includes three types of an independently foamed material (dry foam material type), continuously foamed material (wet foam material type) and dual layer composite material (laminated material type). Among them, the dual layer composite material (laminated material type) is preferable. Foaming may be uniform or non-uniform.

The polishing pad of the present invention may further contain abrasives (for example ceria, silica, alumina or resin) used for polishing. The pad may be soft or rigid, and layers having different hardness are preferably used for respective layers of the laminate. The material of the pad is preferably a non-woven fabric, artificial leather, polyamide, polyurethane, polyester or polycarbonate. The surface to be in contact with the surface to be polished may beprocessed so as to have a lattice of grooves, holes, concentric grooves or helical grooves.

The polishing object (substrate or wafer) to be polished by the polishing method of the present invention will be described below.

### (Metal wiring material)

The polishing object of the present invention is preferably a substrate (wafer) comprising wiring containing copper or a copper alloy. A copper alloy including silver is suitable as the metal wiring material among the copper alloys. The content of silver in the copper alloy is 10% by mass or less. The effect of silver is excellent at a silver content of 1% by mass or less, and is most excellent in the copper alloy that contains silver in the range of from 0.00001 to 0.1% by mass.

### (Width of wiring)

The polishing object is a wiring having a half pitch of preferably 0.15 µm or less, more preferably 0.10 µm or less, and furthermore preferably 0.08 µm or less in DRAM device systems.
On the other hand, the wiring has a half pitch of preferably 0.12 µm or less, more preferably 0.09 µm or less, and furthermore preferably 0.07 µm or less in MPU device systems.
The polishing liquid of the present invention exhibits a particularly excellent effect against the polishing object having the above-mentioned wiring.

### (Barrier metallic material)

A barrier layer is provided between the copper wiring and insulation film (including an interlayer insulation film) in the polishing object of the present invention in order to prevent copper from being diffused. A low resistance metallic material, for example TiN, TiW, Ta, TaN, W or WN, is preferable as the barrier metal material constituting the barrier layer, and Ta or TaN is more preferable among these materials.

### EXAMPLES

While the present invention is described with reference to examples, the present invention is by no means restricted to these examples.

### [Examples 1A to 10A, and Comparative examples 1A to 7A]

Polishing liquids 101A to 110A and 201A to 207A were prepared as shown in Table 1 below, and the polishing liquids were used for polishing tests and evaluations.

### (Preparation of metal-polishing liquid)

The following components were mixed to prepare each metal-polishing liquid.
- Heterocyclic compounds: compounds shown in Table 1: 0.5 mmol/L (or no addition)
- Abrasives: colloidal silica shown in Table 1: 2 g/L
- Organic acid: dihydroxyethyl glycine: 0.18 mol/L
- Oxidant: hydrogen perocide : 9 g/L
The total volume was adjusted to 1000 mL by adding pure water, and the pH was adjusted to 6.5 by adding aqueous ammonia and/or sulfuric acid.

### [Examples 1B to 10B, and Comparative Examples 1B to 4B]

Polishing liquids 101B to 110B and 201B to 204B were prepared as shown in Table 2 below, and the polishing liquids were used for polishing tests and evaluations.

### (Preparation of metal-polishing liquid)

The following components were mixed to prepare each metal-polishing liquid.
- Triazole compounds: compounds shown in Table 1: 0.3 mmol/L (or no addition)
- Abrasives: colloidal silica shown in Table 2: 1.5 g/L
- Organic acid: compounds shown in Table 2: 0.24 mol/L
- Oxidant: hydrogen peroxide: 7 g/L
   The total volume was adjusted to 1000 mL by adding pure water, and the pH was adjusted to 6.5 with aqueous ammonia and/or sulfuric acid.

### (Colloidal silica used in the example)

The specified colloidal silica was prepared as follows by covering a part of the surface with aluminum, and the ratio of (the number of introduced aluminum atoms)/(the number of silicon atoms on the surface) was 1%. The size (volume equivalent diameter) of the specified colloidal silica was 45 nm when measured by the above-mentioned method.
Conventional colloidal silica other than the specified colloidal silica, in which silicon atoms on the surface are not substituted with aluminum atoms, (trade name: PL3, manufactured by Fuso Chemical Co., Ltd., volume average particle diameter = 40 nm), was also used. In the table 1, this conventional colloidal silica is described as non-specified colloidal silica.

### (Preparation of the specified colloidal silica)

Aqueous ammonia was added to 1000 g of an aqueous dispersion solution (20% by mass) of colloidal silica with a size (volume equivalent diameter) of 40 nm, and the pH was adjusted to 9.0. An aqueous solution of sodium aluminate (15.9 g: Al₂O₃ concentration; 3.6% by mass, Na₂O/ Al₂O₃ molar ratio; 1.50) was slowly added to the dispersion solution within several minutes, and the solution was stirred for 0.5 hours. The sol obtained was placed in a SUS autoclave, and was heated at 130°C for 4 hours. Then, the sol solution was sequentially passed through a column filled with a strongly acidic cation exchange resin (trade name: Amberlite IR-120B, hydrogen type) and a column filled with a strongly basic anion exchange resin (trade name: Amberlite IRA-410, hydroxide type) at room temperature at a space velocity of 1 h⁻¹, and the first fraction was discarded.
The surface atom substitution ratio (the number of introduced aluminum atoms/the number of surface silicon atom site) of the specified colloidal silica thus obtained was determined as follows.
The amount of consumed sodium aluminate of the amount of sodium aluminate added to the dispersion solution was calculated from the amount of unreacted sodium aluminate remaining after the reaction. The surface atom substitution ratio was estimated from the surface area calculated from the diameter of colloidal silica, the specific gravity (2.2) of colloidal silica and the number of silanol group per unit surface area (5 to 8 atoms/nm²) on the assumption that the reaction rate of consumed sodium aluminate is 100%.

### (Polishing test)

The polishing speed, erosion and dishing were evaluated by polishing under the following conditions.
- Polishing apparatus: FREX 300 (manufactured by Ebara Corporation)
- Polishing object (wafer):
   (1) for calculating the polishing speed; a blanket wafer with a diameter of 300 mm prepared by forming a Cu film on a silicon substrate with a thickness of 1 µm.
   (2) for evaluating erosion or dishing; copper wiring wafer with a diameter of 300 mm (patterned wafer: mask pattern 745 CMP (manufactured by ATDF Co.)
- Polishing pad: ICI 400 XY-K Groove (manufactured by Rodel Co.)
- Polishing condition:
   polishing pressure (contact pressure between the surface to be polished and polishing pad): 10,324 Pa
   polishing liquid feed speed: 200 ml/minute
   rotation speed of polishing platen: 100 rpm
   rotation speed of polishing head: 50 rpm

### (Evaluation method)

### -Calculation of polishing speed-

The blanket wafer in (1) was polished for 60 seconds, each thickness of the metal film before and after polishing was determined from the electrical resistance at evenly distributed 49 positions on the surface of the wafer, and the average value of the thickness divided by the polishing time was defined as the polishing speed.

### -Evaluation of erosion-

The patterned wafer in (2) was polished for a time period of the time required for completely polishing copper of non-wiring portions plus 20% excess of the above-mentioned polishing time. The step height of line-and-space portions (line 100 µm, space 100 µm) was measured with a contact step height meter (trade name: DEKTAK V3201, manufactured by Veeco Co.).

### -Evaluation of dishing-

The patterned wafer in (2) was polished for a time period of the time required for completely polishing copper of non-wiring portions plus 30% excess of the above-mentioned polishing time. The step height of line-and-space portions (line 100 µm, space 100 µm) was measured with a contact step height meter (trade name: DEKTAK V3201, manufactured by Veeco Co.).
The results of evaluation are shown in Tables 1 and 2.

**TABLE 1**

| | Polishing Liquid | Heterocyclic Compound | Colloidal Silica | Polishing Speed (nm/min) | Erosion (nm) |
|---|---|---|---|---|---|
| EXAMPLE 1A | 101A | Pyridine | Specified Colloidal Silica | 804 | 43 |
| EXAMPLE 2A | 102A | Pyridine-3,4-dicarboxylic Acid | Specified Colloidal Silica | 746 | 29 |
| EXAMPLE 3A | 103A | Quinoline | Specified Colloidal Silica | 799 | 40 |
| EXAMPLE 4A | 104A | Quinoline-2-carboxylic Acid | Specified Colloidal Silica | 741 | 28 |
| EXAMPLE 5A | 105A | Imidazole | Specified Colloidal Silica | 805 | 39 |
| EXAMPLE 6A | 106A | Imidazole-4-carboxylic Acid | Specified Colloidal Silica | 760 | 27 |
| EXAMPLE 7A | 107A | Benzimidazole | Specified Colloidal Silica | 783 | 36 |
| EXAMPLE 8A | 108A | Pyrazole | Specified Colloidal Silica | 782 | 29 |
| EXAMPLE 9A | 109A | Indazole | Specified Colloidal Silica | 767 | 35 |
| EXAMPLE 10A | 110A | Indazole-3-carboxylic Acid | Specified Colloidal Silica | 735 | 27 |
| COMPARATIVE EXAMPLE 1A | 201A | None | Specified Colloidal Silica | 805 | 95 |
| COMPARATIVE EXAMPLE 2A | 202A | Pyridine | Non-Specified Colloidal Silica | 829 | 110 |
| COMPARATIVE EXAMPLE 3A | 203A | Pyridine-3,4-dicarboxylic Acid | Non-Specified Colloidal Silica | 777 | 109 |
| COMPARATIVE EXAMPLE 4A | 204A | Quinoline | Non-Specified Colloidal Silica | 821 | 107 |
| COMPARATIVE EXAMPLE 5A | 205A | Imidazole | Non-Specified Colloidal Silica | 823 | 108 |
| COMPARATIVE EXAMPLE 6A | 206A | Pyrazole | Non-Specified Colloidal Silica | 800 | 108 |
| COMPARATIVE EXAMPLE 7A | 207A | None | Non-Specified Colloidal Silica | 830 | 120 |

**TABLE 2**

| | Polishing Liquid | Heterocyclic Compound | Colloidal Silica | Organic Acid | Polishing Speed (nm/min) | Dishing (nm) |
|---|---|---|---|---|---|---|
| EXAMPLE 1B | 101B | 1,2,3-Triazole | Specified Colloidal Silica | Dihydroxyethyl glycine | 765 | 58 |
| EXAMPLE 2B | 102B | 1,2,4-Triazole | Specified Colloidal Silica | Dihydroxyethyl glycine | 754 | 59 |
| EXAMPLE 3B | 103B | Benzotriazole | Specified Colloidal Silica | Dihydroxyethyl glycine | 721 | 73 |
| EXAMPLE 4B | 104B | 3-Hydroxy-1,2,4-triazole | Specified Colloidal Silica | Dihydroxyethyl glycine | 710 | 50 |
| EXAMPLE 5B | 105B | 1,2,3-Triazole-4,5-dicaroxylic Acid | Specified Colloidal Silica | Dihydroxyethyl glycine | 706 | 44 |
| EXAMPLE 6B | 106B | 1,2,3-Triazole-4,5-dicaroxylic Acid | Specified Colloidal Silica | β-alanine | 710 | 44 |
| EXAMPLE 7B | 107B | 1,2,3-Triazole-4,5-dicaroxylic Acid | Specified Colloidal Silica | Tricin | 702 | 45 |
| EXAMPLE 8B | 108B | 1,2,3-Triazole-4,5-dicaroxylic Acid | Specified Colloidal Silica | Nitrilotrimethylene (phosphonic acid) | 707 | 61 |
| EXAMPLE 9B | 109B | 1,2,3-Triazole-4,5-dicaroxylic Acid | Specified Colloidal Silica | Malic acid | 705 | 68 |
| EXAMPLE 10B | 110B | 1,2,3-Triazole-4,5-dicaroxylic Acid | Specified Colloidal Silica | Oxalic acid | 714 | 78 |
| COMPARATIVE EXAMPLE 1B | 201B | None | Specified Colloidal Silica | Dihydroxyethyl glycine | 803 | 169 |
| COMPARATIVE EXAMPLE 2B | 202B | 1,2,3-Triazole | Non-Specified Colloidal Silica | Dihydroxyethyl glycine | 798 | 126 |
| COMPARATIVE EXAMPLE 3B | 203B | 1,2,4-Triazole | Non-Specified Colloidal Silica | Dihydroxyethyl glycine | 775 | 131 |
| COMPARATIVE EXAMPLE 4B | 204B | None | Non-Specified Colloidal Silica | Dihydroxyethyl glycine | 868 | 120 |

Table 1 and Table 2 show that the chemical-mechanical polishing method using the second metal-polishing liquid according to the present invention (polishing method of the present invention) permits a high polishing speed of 700 nm/minute or more and low dishing to be compatible. Dishing was particularly small when a heterocyclic compound having at least one carboxylic acid group was used, when 1,2,3-triazoe, 1,2,4-triuazole or derivatives thereof was used, or when amino acids were used as the organic acids, and the effect of the present invention was evident.

The foregoing description of the embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.
All publications, patent applications, and technical standards mentioned in this specification are herein incorporated by reference to the same extent as if each individual publication, patent application, or technical standard was specifically and individually indicated to be incorporated by reference.

## Claims

1. A metal-polishing liquid comprising:
at least one heterocyclic compound having from one to three nitrogen atom as heteroatoms in a molecule; and
colloidal silica having a surface partially covered with aluminum.

2. The metal-polishing liquid according to claim 1, wherein the heterocyclic compound has at least one carboxylic group.

3. The metal-polishing liquid according to claim 1, wherein the heterocyclic compound has a plurality of carboxylic groups.

4. The metal-polishing liquid according to claim 1, wherein the pH thereof is in a range of from 5 to 8.

5. The metal-polishing liquid according to claim 1, wherein the heterocyclic compound is 1,2,3-triazole, 1,2,4-triazole or a derivative thereof.

6. The metal-polishing liquid according to claim 1, further comprising at least one organic acid.

7. The metal-polishing liquid according to claim 6, wherein the organic acid is an amino acid.

8. The metal-polishing liquid according to claim 1, wherein an average value of the volume equivalent diameter of the colloidal silica is in the range of from 10 nm to 60 nm.

9. The metal-polishing liquid according to claim 1, wherein the surface atom substitution ratio (number of introduced aluminum atoms / number of surface silicon atoms) is in the range of from 0.01% to 10%.

10. The metal-polishing liquid according to claim 1, wherein the surface atom substitution ratio (number of introduced aluminum atoms / number of surface silicon atoms) is particularly in the range of from 0.1% to 5%.

11. The metal-polishing liquid according to claim 1, wherein a ratio of a content of the heterocyclic compound with respect to a content of the colloidal silica (heterocyclic compound / colloidal silica) is in the range of from 0.00002 to 1000.

12. A chemical-mechanical polishing method comprising:
supplying the metal-polishing liquid according to claim 1 to a polishing pad on a polishing platen;
rotating the polishing platen;
relatively moving the polishing pad while the polishing pad is contacted with a surface to be polished of an object to be polished to polish the surface to be polished of the object to be polished.

13. The chemical-mechanical polishing method according to claim 12, wherein the polishing object is a substrate comprising wiring comprising copper or a copper alloy.

14. The chemical-mechanical polishing method according to claim 13, wherein the copper alloy contains silver in the range of from 0.00001 to 0.1% by mass.

15. The chemical-mechanical polishing method according to claim 12, wherein object to be polished has an insulating film provided on wiring comprising copper or a copper alloy, and a barrier layer containing Ta or TaN is provided between the wiring and the insulating film.

16. The chemical-mechanical polishing method according to claim 12, wherein the contact pressure between the surface to be polished and the polishing pad is in the range of form 6,500 to 14,000 Pa.

17. The chemical-mechanical polishing method according to claim 12, wherein the rotation speed of the polishing platen is in the range of from 50 to 200 rpm.

18. The chemical-mechanical polishing method according to claim 14, wherein an amount of supplying the metal-polishing liquid to a polishing pad is in a range of from 50 to 500 ml/min.
